Europäisches Patentamt

European Patent Office

Office européen des brevets

(11) Publication number: 0 294 602 A2

# EUROPEAN PATENT APPLICATION

(21) Application number: 88107495.9

(51) Int. Cl.4: H03K 19/003

(22) Date of filing: 10.05.88

(30) Priority: 12.06.87 US 61246

(43) Date of publication of application:
14.12.88 Bulletin 88/50

(84) Designated Contracting States:
DE FR GB

(71) Applicant: International Business Machines
Corporation
Old Orchard Road
Armonk, N.Y. 10504(US)

(72) Inventor: Dorler, Jack Arthur
Rte 2 Box 212A
Holmes New-York 12531(US)
Inventor: Maley, Gerald Adrian
14 Lookout Road
Fishkill New York 12524(US)
Inventor: Mosley, Joseph Michael
4800 NW 28th Way
Boca Raton Florida(US)
Inventor: Weitzel, Stephen Douglas
10 North Drive
Poughkeepsie New-York 12603(US)

(74) Representative: Bonin, Jean-Jacques
Compagnie IBM France Département de
Propriété Intellectuelle
F-06610 La Gaude(FR)

(54) Fault tolerant logical circuitry.

(57) Fault tolerant logic circuitry wherein the logic gate circuits employed therein each include an input circuit portion and a push-pull output circuit portion. The push-pull output circuit portion of each of said logic gates employed in said fault tolerant logic circuitry having the characteristic that when an output of a first logic gate circuit is connected to an output of a second logic gate circuit, said connection between the outputs of said first and second logic gate circuits will provide a predetermined logical function.

FIG. 2

## FAULT TOLERANT LOGICAL CIRCUITRY

### Cross Reference to Related Application :

U.S. Patent Application (FI9-84-057) Serial No. 792,097 entitled "Dual Fault-Masking Redundancy Logic Circuits" filed October 28, 1985 by W. Y. Wang.

U.S. Patent Application (FI9-86-034) Serial No. 037306 entitled "Fault Tolerant Logical Circuitry" filed April 10, 1987 by Gerald A. Maley et al.

### Technical Field

The invention relates to logic circuits. More particularly, the invention relates to a fault tolerant logic circuit design employing gate circuits having push-pull output circuit means and interwoven input and output circuit paths.

### Background of the Invention

The trend for digital logic is higher performance and higher density. Each of these is important to establish smaller, faster data processing equipment. As the semiconductor chip density increases, the importance of any one defect increases, since it represents a larger portion of the product. One small defect can render a chip useless. The larger the chip size the more likely the defect will occur on a chip, thus resulting in a lower yield. To increase yield due to random defects losses in logic circuits, one can add redundant circuitry. One such technique was disclosed by Klaschka (US patent No. 3,543,048). In figure 3(b) of Klaschka a technique of rejecting defects is shown. This technique will reject many defects, such as opens in the logic gate to logic gate wiring. The redundant logic signal path provides logic signal continuity for open wires and certain logic gate defects.

### Background Art

There is a large number of redundant and fault tolerant circuits known to the art. It is to be appreciated with reference to the subject invention, that, the following art is not submitted to be the only prior art, the best prior art, or the most pertinent prior art.

2,910,584 entitled "Voted-Output Flip-Flop Unit" granted October 27, 1959 to F. G. Steele.

3,016,517 entitled "Redundant Logic Circuitry" granted January 9, 1962 to B. R. Saltzberg.

3,134,032 entitled "Error Canceling Decision Circuit" granted May 19, 1964 to W. C. Mann.

3,305,830 entitled "Error Correcting Redundant Logic Circuitry" granted February 21, 1967 to G. Constantine, Jr.

3,451,042 entitled "Redundant Signal Transmission System" granted June 17, 1969 to P. A. Jensen et al.

3,543,048 entitled "Redundant Binary Logic Circuits" granted November 24, 1970 to T. F. Klascka.

3,900,741 entitled "Fault Tolerant Clock Apparatus Utilizing A Controlled Minority of Clock Elements" granted August 19, 1975 to J. C. Fletcher et al.

4,199,799 entitled "Supervisory Circuit For Redundant Channel Control Systems" granted April 22, 1980 to A. L. Ostenso et al.

4,215,340 entitled "Process for the Automatic Signalling of Faults of A Static Automatic Module For Realizing The Process" granted July 29, 1980 to J. Lejon.

4,276,643 entitled "Method of and Means For Routing Binary Messages Through A Multinode Data-Transmission System" granted June 30, 1981 to J. Lapier et al.

4,283,640 entitled "ALL-NPN Transistor Driver and Logic Circuit" granted August 11, 1981 to R. L. Konian et al.

4,458,159 entitled "Large Swing Driver/Receiver Circuit" granted July 3, 1984 to R. L. Konian.

There are a number of redundancy techniques known to the art. One example is disclosed in the Klaschka patent (U.S. Patent 3,543,048 November 25, 1970). Klaschka employs a redundant signal path to provide defect rejecting circuitry. Klaschka's circuitry and technique will not reject (obviate) a short circuit between a first logic path and a second independent logic path where each logic path includes a signal line path and a redundant signal line path. Applicant's invention will reject (obviate) a short circuit between a first logic path and a second independent logic path where each logic path includes a signal line path and a redundant signal line path.

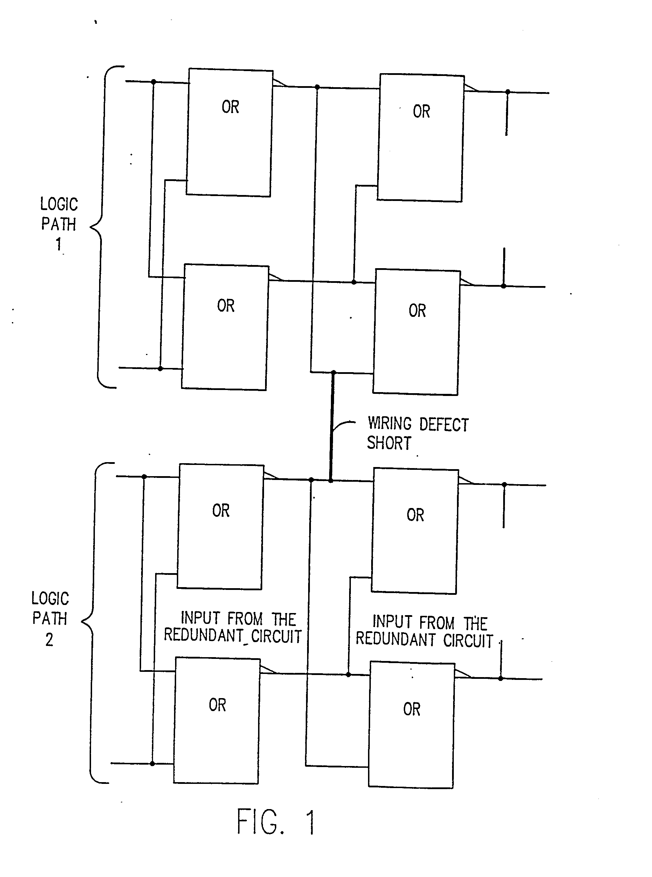

One common defect in the semiconductor process is short circuits between the wiring levels. The wiring levels are separated by an insulating material which keeps the wires isolated and prevents short circuiting. However, defects occur in the insulating material which allow the normally isolated wires to become connected together, forming an unwanted electrical path which changes the logic gate circuit function. Figure 1 illustrates wiring defect shorting two different logic signals. In this figure there are two different logic signal paths - Path 1 and Path 2. Each logic gate in the logic circuit is a 'NOR' logic circuit. Logic path 1 illustrates both a signal path and an associated redundant signal path. Logic path 2 illustrates a signal path and an associated redundant signal path. The circuit comprising the individual logic gates determines the result of this short circuit connection. For example, should the logic gate circuit be a current switch circuit with an emitter follower output, the result of the short circuit would be a logical 'OR' function between the two output signals. The operation of a current switch is explained in "Electronic Circuits, Digital and Analog" by Charles A. Holt, John Wiley and Sons Inc., copyright 1978. If path 2 has a logic high level at the position of the defect and path 1 has a logic low level at the position of the defect, then, as a result of the electrical short circuit, both logic paths would have a logic high signal. By the nature of the circuits, this logic high level would dominate both logic paths. Logic path 1 would have the incorrect logic high level applied to both the signal path and the redundant signal path causing the incorrect logic level to propagate through the remainder of the logic path. To reject an electrical short circuit between two independent logic signal paths, the electrical short circuit must produce a logic low level. The logic low level would permit the redundant signal path to provide the correct signal and reject the error signal. For NOR logic circuits, logic low level is an inactive logic level.

To those skilled in the art, it will now be apparent that the electrical short circuit must produce a logical 'OR' function between the two connected circuits to allow the redundant 'NAND' circuits to reject the short circuit.

Figure 1 illustrates the invention with a wiring defect shorting two different logic signals utilizing 'OR' logic gates. This figure is also applicable to 'AND' logic gates. In the example of 'AND' logic gates, each of the logic gates in logic path 1 and logic path 2 would utilize 'NAND' logic gates. As described above for the 'NOR' logic gates, logic path 1 illustrates both the signal path and the associated redundant signal path. Path 2 illustrates the signal path and the associated redundant signal path. The circuit comprising the individual logic gates determines the result of this short circuit connection. For example, should the logic gate circuit be a TTL circuit with an open collector and pull up resistor output, the result of the short circuit would be a logical 'AND' function between the two output signals. The operation of a TTL circuit is explained in "Electronic Circuits, Digital and Analog" by Charles A. Holt, John Wiley and Sons Inc.,

copyright 1978. If path 2 has a logic high level at the position of the defect and path 1 has a logic low level at the position of the defect, then, as a result of the electrical short circuit, both logic paths would have a logic low signal. By the nature of the circuits, this logic low level would dominate both logic paths. Logic path 1 would have the incorrect logic low level applied to both the signal path and the redundant signal path causing the incorrect logic level to propagate through the remainder of the logic path. To reject an electrical short circuit between two independent logic signal paths, the electrical short circuit must produce a logic high level. The logic high level would permit the redundant signal path to provide the correct signal and reject the error signal. For 'NAND" logic gates, a logic high level is an inactive logic level.

To those skilled in the art, it will now be apparent that the electrical short circuit must produce a logical 'AND' function between the two connected circuits to allow the redundant 'NOR' circuits to reject the short circuit.

The Low Voltage Inverter circuit, described in ELECTRONICS 4, 41 - 42 (February 24, 1981) and U.S.A. patent 4,283,640, may be utilized in the Klaschka type circuitry to provide redundancy for a logic circuit. This circuit is high performance and low power which makes it suitable for VLSI applications. However, like the current switch circuit in the example described above, the Low Voltage Inverter circuit is a logical 'NOR' circuit and thus unable to reject inter-net short circuits. When two Low Voltage Inverter circuit outputs are electrically connected, the resulting signal is a logical 'OR' of the two output signals. As was described above, to reject inter-net short circuits, two 'NOR' logic gates with outputs electrically connected must produce a logical 'AND' function at the connection point.

## Summary of the Invention

A primary object of the invention is to provide an improved fault tolerant logic circuitry.

A further primary object of the invention is to provide an improved logic gate circuit for use in a fault tolerant logic circuit.

It is an object of this invention to provide a high performance logic circuit which is able to have two circuit outputs tied together and produce a logical 'AND' of the two output signals.

Another object of this invention is to provide a NOR logic gate circuit which has a push-pull output drive and provides a logical 'AND' when electrically connected to another logic gate of the same type.

Yet another object of this invention is to provide a logic gate circuit capable of rejecting inter-net short circuits for a redundant logic circuit.

These and other objects of this invention may be accomplished by creating a first logic gate circuit which allows the output signal to be changed from a active logic level to an inactive logic level by a second same circuit connected to the output of the first logic gate circuit.

The logic gate consists of driver transistor the emitter of which is connected to the circuit output and the collector which is connected to a shift resistor. The remaining end of the shift resistor is connected to the positive power supply, Vcc. A Schottky Barrier Diode is connected between the driver transistor base and collector to eliminate saturation in the driver transistor. Another Schottky Barrier Diode and a resistor are connected in parallel between the positive power supply and the driver transistor base. A switching transistor collector is connected to the driver transistor base and the switching transistor base is connected to an input signal which is derived from other logic gate circuits. A first current limiting resistor is connected in parallel with a first speedup capacitor between the emitter of the first switching transistor and the negative supply, ground. A second switching transistor collector is connected to the driver transistor emitter and the second switching transistor base is connected to the same input signal which is derived from other logic gate circuits. A second current limiting resistor is connected in parallel with a second speedup capacitor between the emitter of the second switching transistor and the negative supply. A Schottky Barrier Diode is connected between the base and collector of the second switching transistor to prevent saturation.

Operation of the circuit of the present invention is as follows: In response to a first input signal, the first and second switching transistors turn on very quickly due to the first and second speedup capacitors respectively, providing a low impedance path to ground. The first switching transistor turning on conducts current through the resistor connected to the positive supply, which causes the voltage to drop at the base of the driver transistor base. When the voltage drop is sufficient, the Schottky Barrier diode, which is connected between the positive power supply and the driver transistor base, turns on and clamps the driver transistor base voltage to a diode drop below the positive power supply. The output signal becomes a driver transistor base to emitter voltage drop below the driver transistor base voltage. The second switching transistor turning on first discharges any parasitic capacitance connected to the circuit output, then the current is conducted through the driver transistor and through the resistor which connects the driver transistor collector to the positive power supply. The current through the driver transistor collector resistor results in a driver transistor collector voltage change which is sufficient to forward bias the Schottky Barrier diode connected between the driver transistor base and collector. The circuit quiescent current is determined by the resistors in the emitters of the first and second switching transistors.

In response to a second input signal, the first and second switching transistors turn off very quickly due to the first and second speedup capacitors respectively, providing a low impedance path to ground. The first switching transistor turning off allows the parallel connected resistor and Schottky Barrier diode to pull the driver transistor base to almost the positive power supply. The output signal becomes a driver transistor base to emitter voltage drop below the driver transistor base voltage. The second switching transistor turning off eliminates its current in the driver transistor, which in turn allows the driver transistor collector resistor to pull the driver transistor collector to almost the positive power supply. The Schottky Barrier diode connected between the driver transistor base and collector becomes reverse biased.

When the outputs of two circuits of the present invention are electrically connected together the following occurs: In response to a first input signal to the first circuit, the first and second switching transistors of the first circuit become active. In this state, the base of the driver transistor of the first circuit is clamped at a Schottky Barrier diode voltage drop below the positive power supply. The output signal of the first circuit is a driver transistor base to emitter voltage drop below the driver transistor base voltage. A second input which is applied to the second circuit causes the first and second switching transistors of the second circuit to be turned off. The current through the second switching transistor of the first circuit is conducted through the driver transistor of the second circuit and through the resistor which connects the driver transistor of the second circuit collector to the positive power supply. The current through the driver transistor collector resistor of the second circuit results in a driver transistor collector voltage change which is sufficient to forward bias the Schottky Barrier diode connected between the base and collector of the driver transistor of the second circuit. The diode current is conducted through the parallel resistor and Schottky Barrier diode combination of the second circuit which results in a voltage drop at the driver transistor base of the second circuit. The output of the second circuit is a base to emitter voltage drop below the base voltage of the driver transistor of the second circuit. The output voltage of the second circuit is sufficiently low to be considered a logic low level.

The foregoing and other objects, features and advantages of the invention will be apparent from the following more particular description of the preferred embodiments of the invention, as illustrated in the drawings.

Brief Description of the Drawings

Figure 1 discloses a block diagram of fault tolerant logic circuitry with an electrical short circuit between two logic paths, where each logic path includes a signal line path and a redundant path.

Figure 2 discloses a logic gate circuit in accordance with the invention and which may preferably be employed in the fault tolerant logical circuitry in accordance with the invention.

Figure 3 illustrates, in accordance with the invention, logic gate circuitry and fault tolerant logic circuitry containing a short circuit between logic paths 1 and 2.

Figure 4 discloses a current switch logic gate in accordance with the invention and which may be employed in the fault tolerant logical circuitry in accordance with the invention.

Figure 5 discloses a TTL logic gate in accordance with the invention and which may be employed in the fault tolerant logical circuitry in accordance with the invention.

Best Mode For Implementing The Invention

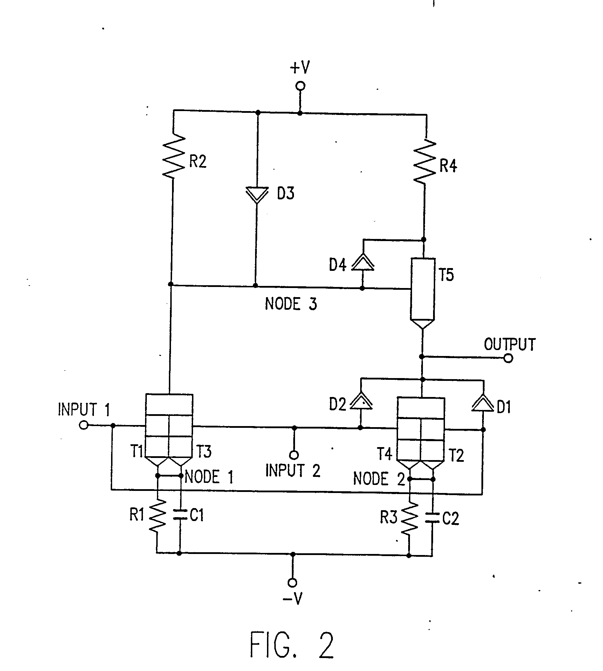

Reference is made to Figure 2. The circuit includes transistors T1, T2, T3, T4, and T5, resistors R1, R2, R3, and R4, Schottky Barrier Diodes D1, D2, D3, and D4, and capacitors C1 and C2. The first input signal is connected to the base of transistors T1 and T2 and to the anode of Schottky Barrier Diode D1. The second input is connected to the base of transistors T3 and T4 and to the anode of Schottky Barrier Diode D2. The collectors of transistors T1 and T3 are connected to resistor R2, the anode of Schottky Barrier Diode D4, the cathode of Schottky Barrier Diode D3, and the base of transistor T5. The emitters of transistors T1 and T3 are connected to resistor R1 and capacitor C1. The collectors of transistors T2 and T4 are connected to the cathodes of Schottky Barrier Diodes D1 and D2, the emitter of transistor T5, and the output signal line. The emitters of transistors T2 and T4 are connected to resistor R3 and capacitor C2. Transistor T5 collector is connected to the cathode of Schottky Barrier Diode D4 and resistor R4. A positive voltage supply is connected to the anode of Schottky Barrier Diode D3 and the opposite ends of previously connected resistors R2 and R4. A negative supply is connected to the opposite ends of previously connected resistors R1 and R3, and capacitors C1 and C2.

The circuit in figure 2 operates as follows. A logic low level on input 1 turns off transistors T1 and T2 which causes the voltage at node 3 to be at voltage drop below the positive power supply equivalent to the product of the base current of transistor T5 and the resistance of R2. The output signal is transistor T5's base to emitter voltage below node 3. This produces a logic high level on the output signal line. No current flows through resistors R1 and R3, capacitors C1 and C2, and diodes D3 and D4. A small amount of current conducted through transistor T5 also flows through resistor R4. A logic high level on input 1 turns on transistors T1 and T2. The current through transistor T1 causes current to flow through resistor R2 and Schottky Barrier Diode D3. The voltage at node 3 is the diode D3 voltage drop below the positive power supply. The output signal voltage is transistor T5's base to emitter voltage drop below node 3 voltage. The current through transistor T2 is conducted through transistor T5 and creates a voltage drop at the collector of transistor T5 due to the current through resistor R4. The voltage drop at the collector of transistor T5 is sufficiently large to forward bias the Schottky Barrier Diode D4. Schottky Barrier Diode D4 does not allow transistor T5 to saturate and decrease the performance of the circuit. Likewise, Schottky Barrier Diode D1 prevents transistor T2 from saturating, thus decreasing the performance of the circuit. Resistor R1 establishes the quiescent current through transistor T1, while resistor R3 establishes the quiescent current through transistor T2. Capacitors C1 and C2 are functional only during the input signal rising and falling transitions. During a changing input signal, the capacitors provide a very low impedance to the negative supply. This causes transistors T1 and T2 to switch on or off quickly, decreasing the delay through the circuit. The combination of transistors T2 and T5 form an output push-pull circuit. This circuit is able to quickly charge and discharge the parasitic capacitances connected to the logic circuit output and thereby decrease the overall delay of the logic circuit.

The additional devices, Schottky Barrier Diode D4 and resistor R4, provide a special function necessary for fault tolerant push-pull output logic circuits. These elements in the circuit of figure 2, allow the fault tolerant circuit to reject inter-level signal to signal short circuits.

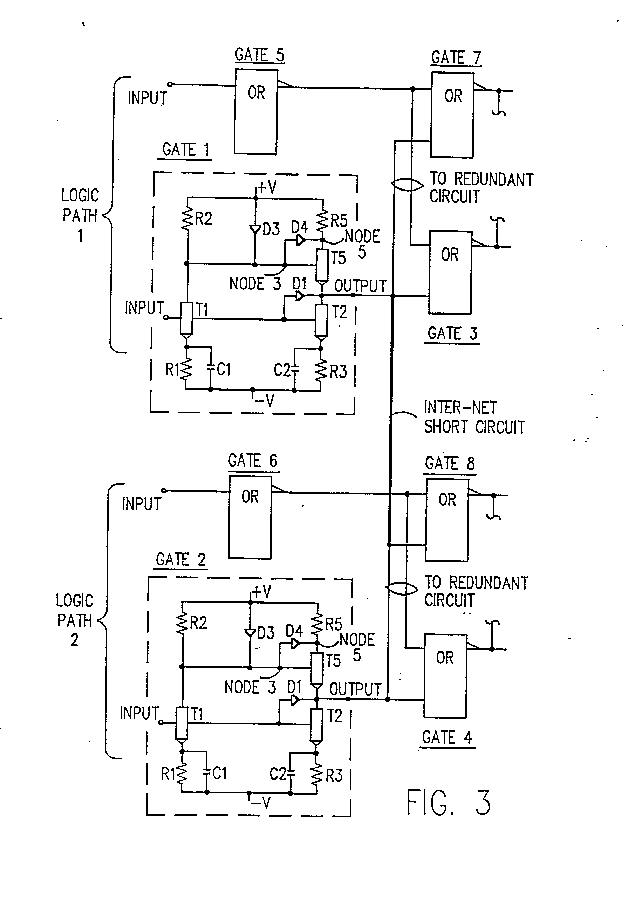

Figure 3 is a simplified schematic showing eight logic gates comprising two independent logic Paths 1 and 2. Logic path 1 has a signal path (gates 1 and 3) and an interconnected redundant signal path (gates 5 and 7). Logic path 2 has a signal path (gates 2 and 4) and an interconnected redundant signal path (gates 6 and 8). Path 1 includes logic gates 1, 3, 5 and 7. The output of logic gate 1 is connected to an input of logic gate 3 and to an input of logic gate 7. Logic gate 5 provides a redundant logic signal to logic gates 3 and 7. Path 2 includes logic gates 2, 4, 6 and 8. The output of logic gate 2 is connected to an input of logic gate 4 and to an input of logic gate 8. Logic gate 6 provides a redundant logic signal to logic gates 4 and 8. Each of the logic gates shown in figure 3 are of the type described previously and are of the preferred embodiment. [It is to be appreciated that logic gate circuits 1, 2, 5 and 6 of Figure 3 correspond identically to the logic gate circuit of Figure 2, with the qualification that the logic gate circuit of Figure 2 may have one, two, three or more inputs. Also a number of outputs may be taken from the output terminal of the logic gate circuit of Figure 2.] Shown in figure 3 is an electrical short circuit between wiring levels causing Path 1 and Path 2 to be electrically connected. Applicant's invention as described above and more fully hereinafter rejects the inter-net short and permits logic paths 1 and 2 to function properly.

Referring to figure 3, the inter-net short circuit is rejected as described in the following four cases. The first case is a logic high level input to both logic gates 1 and 2. The second case is a logic low level input to both logic gates 1 and 2. The third case is logic high level input to logic gate 1 and logic low level input to logic gate 2. The last case is a logic low level input to logic gate 1 and a logic high level input to logic gate 2.

The first and second cases are trivial. A logic high level input to both logic gates 1 and 2 produces a logic low level at the output of both logic gates 1 and 2. Since both logic gates are at the same logic level, the inter-net short circuit does not disturb the outputs or change the function of logic paths 1 and 2. The inter-net short has no effect on the logic gates. In the same manner, a logic low level at the input of logic gates 1 and 2 produces a logic high level at the output of both logic gates 1 and 2. Since both logic gates are at the same logic level, the inter-net short circuit does not disturb the outputs or change the function of logic paths 1 and 2. The inter-net short has no effect on the logic gates.

The third case to consider is a logic high level input to logic gate 1 and a logic low level input to logic gate 2. The output of logic gate 1 will be a logic low level while the output of logic gate 2 will be a logic high level. The inter-net short causes the two circuits to be electrically connected. As previously described, a logic high level at the input of logic gate 1 causes transistors T1 and T2 of logic gate 1 to conduct current. The current through transistor T1 of logic gate 1 causes current to flow through resistor R2 and Schottky Barrier Diode D3 of logic gate 1. The voltage at node 3 is the diode D3 voltage drop below the positive power supply. The output signal voltage of logic gate 1 is transistor T5's base to emitter voltage drop below node 3 voltage. The collector of transistor T2 of logic gate 1 is connected to both the emitter of transistor T5 and the cathode of Schottky Barrier Diode D1 of logic gate 1 and is also connected through the inter-net short to the emitter of transistor T5, collector of transistor T2, and the cathode of Schottky Barrier Diode D1 of logic gate 2. The logic low level on input 1 of logic gate 2 turns off transistors T1 and T2 of logic gate 2 which causes the voltage at node 3 to be at a voltage drop below the positive power supply equivalent to the product of the base current of transistor T5 and the resistance of R2. The output signal voltage of logic gate 2 is transistor T5's base to emitter voltage below node 3. This produces a logic high level on the output signal line of logic gate 2. No current flows through resistors R1 and R3, and capacitors C1 and C2. The inter-net short circuit defect allows transistor T2 of logic gate 1 to conduct current through transistor T5 of logic gate 2. The current through transistor T5 of logic gate 2 is conducted through resistor R5 which causes the voltage at node 5 to drop sufficiently low to turn on Schottky Barrier Diode D4 of logic gate 2. The current for diode D4 of logic gate 2 is conducted through resistor R2 and diode D3 of logic gate 2 producing a voltage drop at node 3 in logic gate 2. This allows the output voltage of logic gate 2 to drop to a logic low level from a logic high level. The input voltage to logic gates 3 and 4 from the electrically connected outputs of logic gates 1 and 2, is a logic low level. Without the inter-net defect electrically connecting logic gates 1 and 2, logic gate 3 should have a logic low level from logic gate 1 and a redundant logic low level from the redundant logic. Logic gate 3 should produce a logic high level at its output. Without the defect electrically connecting logic gates 1 and 2, logic gate 4 should have a logic high level from logic gate 2 and a redundant logic high level from the redundant logic gate 6. Logic gate 4 should produce a logic low level at its output. With the defect, logic gate 3 has two logic low levels and continues to produce a logic high level at its output. With the defect, logic gate 4 now has a logic low level from the input with the inter-net short and a logic high level from the redundant input. Due to the redundant signal, logic gate 4 will produce a logic low level output.

The fourth case to consider is a logic high level input to logic gate 2 and a logic low level input to logic gate 1. The output of logic gate 2 will be a logic low level while the output of logic gate 1 will be a logic high level. The inter-net short causes the two circuits to be electrically connected. As previously described, a logic high level at the input of logic gate 2 causes transistors T1 and T2 of logic gate 2 to conduct current. The current through transistor T1 of logic gate 2 causes current to flow through resistor R2 and Schottky Barrier Diode D3 of logic gate 2. The voltage at node 3 is the diode D3 voltage drop below the positive power supply. The output signal voltage of logic gate 2 is transistor T5's base to emitter voltage drop below node 3 voltage. The collector of transistor T2 of logic gate 2 is connected to both the emitter of transistor T5 and the cathode of Schottky Barrier Diode D1 of logic gate 2 and is also connected through the inter-net short to the emitter of transistor T5, collector of transistor T2, and the cathode of Schottky Barrier Diode D1 of logic gate 1. The logic low level on input 1 of logic gate 1 turns off transistors T1 and T2 of logic gate 1 which causes the voltage at node 3 to be at a voltage drop below the positive power supply equivalent to the product of the base current of transistor T5 and the resistance of R2. The output signal voltage of logic gate 1 is transistor T5's base to emitter voltage below node 3. This produces a logic high level on the output signal line of logic gate 1. No current flows through resistors R1 and R3, and the capacitors C1 and C2. The inter-net short circuit defect allows transistor T2 of logic gate 2 to conduct current through transistor T5 of logic gate 1. The current through transistor T5 of logic gate 1 is conducted through resistor R5 which causes the voltage at node 5 to drop sufficiently low to turn on Schottky Barrier Diode D4 of logic gate 1. The current for diode D4 of logic gate 1 is conducted through resistor R2 and diode D3 of logic gate 1 producing a voltage drop at node 3 in logic gate 1. This allows the output voltage of logic gate 1 to drop to a logic low level from a logic high level. The input voltage to logic gates 3 and 4 from the electrically connected outputs of logic gates 1 and 2, is a logic low level. Without the defect electrically connecting logic gates 1 and 2, logic gate 4 should have a logic low level from logic gate 2 and a redundant logic low level from the redundant logic gate 6. Logic gate 4 should produce a logic high level at its output. Without the defect electrically connecting logic gates 1 and 2, logic gate 3 should have a logic high level from logic gate 1 and a redundant logic high level from the redundant logic gate 6. Logic gate 3 should produce a logic low level at its output. With the defect, logic gate 4 has two logic low levels and continues to produce a logic high level at its output. With the defect, logic gate 3 now has a logic low level from the input with the inter-net short and a logic high level from the redundant input. Due to the redundant signal, logic gate 3 will produce a logic low level output.

The above description shows the invention is capable of rejecting inter-net shorts by using logic gate redundancy and logic gate circuits which provide a logical 'AND' signal when the outputs are electrically connected.

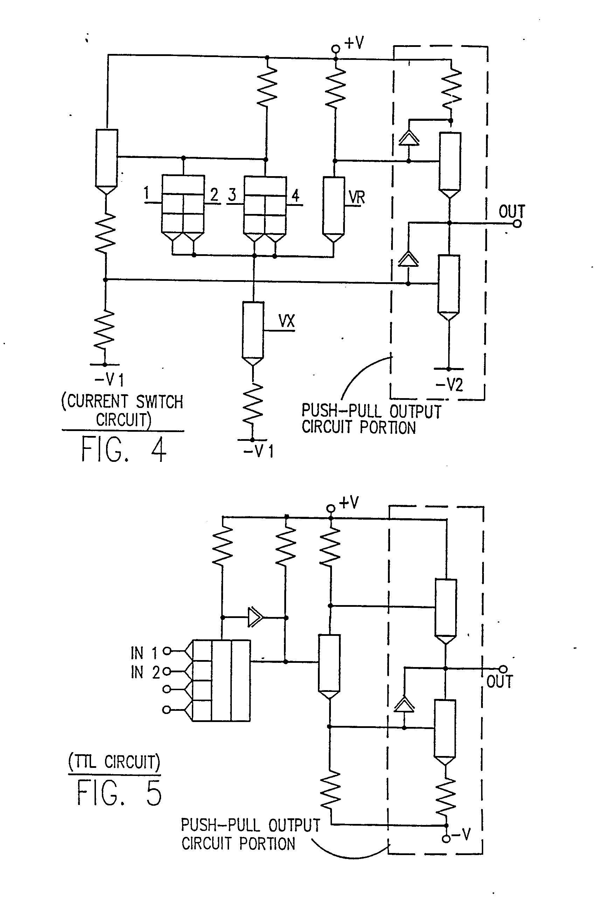

Reference is made to Figure 4, which discloses a current switch logic gate circuit having a push-pull output circuit portion in accordance with the invention. It will be apparent that the logic gate circuit of Figure 4 will provide a logical 'AND' signal when the outputs are electrically connected.

Reference is made to Figure 5, a TTL logic gate circuit having a push-pull output circuit portion. The output drive circuit differs from the 'NOR' logic circuit output drive to produce a logical 'OR' when the output of two TTL logic gates are electrically connected together. The output drive circuit for the TTL logic gate utilizes an upper transistor, a lower transistor with a base to collector Schottky Barrier Diode, and resistor connected between the emitter of the lower transistor and the -V power supply. As in the operation of all push-pull circuits, the upper transistor provides the low impedance drive for the output signal positive transition, while the lower transistor provides the low impedance drive for the output signal negative transition. The Schottky Barrier Diode connected between the base and collector of the lower transistor prevents the lower transistor from saturating. The resistor, connected between the lower transistor emitter and the -V power supply, limits the current in the lower transistor.

The operation of the 'NAND' push-pull output drive circuit for the case of two circuits connected together at the output is as follows: Two circuits have logic signals applied to their respective inputs such that the output of logic gate 1 is a logic high level and the output of logic gate 2 is a logic low level. The upper transistor of logic gate 2 is turned off and therefore not conducting. The lower transistor of logic gate 2 is turned on and conducting current through the resistor connected between its emitter and the -V power supply. The lower transistor of logic gate 1 is turned off and therefore not conducting. The upper transistor of logic gate 1 provides the logic high level output for both logic gate 1 and the electrically connected logic gate 2. Since the upper transistor of logic gate 1 is forcing the output of logic gate 2 to a logic high level, the current conducted by the lower transistor of logic gate 2 is conducted through the upper transistor of logic gate 1. The resistor, connected between the emitter of the lower transistor of logic gate 2 and the -V power supply, limits the current which is conducted through the lower transistor of logic gate 2 and the upper transistor of logic gate 1.

It will be apparent that the logic gate circuits of Figures 4 and 5 will provide the appropriate inactive logic signal to allow the redundant circuits to reject (obviate) the erroneous signal when the circuits outputs are electrically connected. Accordingly, it is to be appreciated that the applicants' invention may be practiced by employing logic gate circuits of the TTL and current switch technology families.

While the invention has been particularly described with reference to the preferred embodiments thereof, it will be understood by those skilled in the art that the foregoing and other changes in form and detail may be made therein without departing from the spirit and scope of the invention.

## Claims

1. A fault tolerant logic circuit capable of obviating one or more short circuits between a first signal path and a second signal path, said fault tolerant logic circuit comprising :
first and second interconnected signal paths;
said first signal path having at least one input, an output and a plurality of logic gate circuits interconnected between said at least one input and output of said first signal path;
said second signal path having at least one input, an output and a plurality of logic gate circuits interconnected between said at least one input and output of said second signal path;
said fault tolerant logic circuit being characterized in that each of said logic gate circuits of said first and second signal paths has an input circuit portion and a push-pull output circuit portion connected to said input circuit portion, each of said input circuit portions of said logic gate circuits of said first and second signal paths has at least first and second inputs, each of said output circuit portions of said logic gate circuits of said first and second signal paths has at least first and second outputs, and said first and second outputs of each of said logic gate circuits is connected to an input of a logic gate circuit in a discrete one of said first and second inter-connected signal paths, whereby short circuits between said first and second signal paths will be obviated.

2. A fault tolerant logic circuit capable of obviating one or more shorts between first and second signal paths, as recited in claim 1, wherein each of said logic gate circuits of said first and second signal paths includes an input circuit portion and a push-pull output circuit portion connected to said input circuit portion, said push-pull output circuit portion including: first and second transistors, said first and second transistors each having an emitter, base and collector, said emitter of said first transistor connected to said collector of said second transistor said base of said first transistor connected to said input circuit portion of said logic gate circuit, said base of said second transistor connected to said input circuit portion of said logic gate circuit, and said emitter of said second transistor connected to a first source of potential;
a resistor connected between said collector of said first transistor and a second source of potential;
a diode having an anode and cathode, said anode of said diode connected to said base of said first transistor, said cathode of said diode connected to said collector of said first transistor; and,
said at least first and second outputs of said logic gate circuit respectively connected to said emitter of said first transistor.

3. A fault tolerant logic circuit capable of obviating one or more shorts between first and second signal paths, as recited in claim 1, wherein each of said logic gate circuits of said first and second signal paths includes an input circuit portion and an interconnected push-pull output circuit portion, said push-pull output circuit portion including :
first and second transistors each having an emitter, base and collector, said emitter of said first transistor connected to said collector of said second transistor, said base of said first transistor connected to said input portion of said logic gate circuit, said base of said second transistor connected to said input circuit portion of said logic gate circuit,
a first resistor connected between said collector of said first transistor and a first source of potential;
a diode having an anode and a cathode, said anode of said diode connected to said base of said first transistor, said cathode of said diode connected to said collector of said first transistor;
a second resistor connected between said emitter of said second transistor and a second source of potential; and
said at least first and second outputs of said logic gate circuit respectively connected to said emitter of said first transistor.

4. A fault tolerant logic circuit capable of obviating one or more short circuits between first and second signal paths, as recited in claim 1, wherein each of said logic gate circuits of said first and second signal paths includes :
first, second, third, fourth and fifth transistors, said first and third transistors having a common collector, said second and fourth transistors having a common collector, said fifth transistor having a collector, said first through fifth transistors each having a base and emitter, said emitters of said first and third transistors connected in common, said emitters of said second and fourth transistors connected in common, said base of said fifth transistor connected to said common collector of said first and third transistors, and said emitter of said fifth transistor connected to said common collector of said second and fourth transistors;

a first input connected in common to said bases of said first and second transistors;

a second input connected in common to said bases of said third and fourth transistors;

a first resistor connected between said common connection of said emitters of said first and third transistors and a first source of potential;

a second resistor connected between said common collector of said first and third transistor and a second source of potential;

a first diode having an anode connected to said second source of potential and a cathode connected to said common collector of said first and third transistors;

a third resistor connected between said common connection of said emitters of said second and fourth transistors and said first source of potential;

a fourth resistor connected between said collector of said fifth transistor and said second source of potential;

a second diode having an anode connected to said base of said fifth transistor and a cathode connected to said collector of said fifth transistor; and

at least first and second outputs respectively connected to said emitter of said fifth transistor.

5. A fault tolerant logic circuit capable of obviating one or more shorts between first and second signal paths, as recited in claim 4, wherein each of said logic gate circuits further includes :

a first capacitor connected in parallel with said first resistor;

a second capacitor connected in parallel with said second resistor;

a third diode having an anode connected to said base of said second transistor and a cathode connected to said common collector of said second and fourth transistors; and,

a fourth diode having an anode connected to said base of said fourth transistor and a cathode connected to said common collector of said second and fourth transistors.

6. A fault tolerant logic circuit capable of obviating one or more short circuits between first and second signal paths, as recited in claim 1, or claim 2, wherein each of said logic gate circuits of said first and second signal paths is a current switch logic gate circuit having an input circuit portion and a push-pull output circuit portion.

7. A fault tolerant logic circuit capable of obviating one or more short circuits between first and second signal paths, as recited in claim 1, or claim 2, wherein each of said logic gate circuits of said first and second signal paths is a TTL logic gate circuit having an input circuit portion and a push-pull output circuit portion.

8. Fault tolerant logic circuitry, said fault tolerant logic circuitry including :

a first logic path, said first logic path having an input for receiving a binary input and an output providing a binary output which is a predetermined logical binary function of said binary input to said first logic path, said first logic path including,

a first signal path, said first signal path connected between said input and output of said first logic path, a first redundant signal path interconnected with said first signal path, said first redundant signal path connected between said input and output of said first logic path, said first signal path and said interconnected redundant first signal path each including a plurality of serially connected logic gate circuits, and each of said logic gate circuits of said first signal path and said first redundant signal path including an input circuit portion and a push-pull output circuit portion;

a second logic path, said second logic path being logically independent from said first logic path, said second logic path having an input for receiving a binary input and an output providing a binary output which is a predetermined logical binary function of said binary input to said second logic path, said second logic path including,

a second signal path, said second signal path connected between said input and output of said second logic path, a second redundant signal path interconnected with said second signal path, said second redundant signal path connected between said input and output of said second logic path, said second signal path and said interconnected redundant second signal path each including a plurality of serially connected logic gate circuits, and each of said logic gate circuits of said second signal path and said second redundant signal path including an input circuit portion and a push-pull output circuit portion; and

said fault tolerant logic circuitry being characterized by each of said logic gate circuits employed in said fault tolerant logic circuitry including an input circuit portion and a push-pull output circuit portion, said push-pull output circuit portion of each of said logic gates employed in said fault tolerant logic circuitry having the characteristic that when an output of a first logic gate circuit is connected to an output of a second logic gate circuit, said connection between the outputs of said first and second logic gate circuits will provide the logical "AND" function.

9. Fault tolerant logic circuitry, as recited in claim 8, wherein each of said logic gate circuits of said first and second logic paths includes an input circuit portion and an interconnected push-pull output circuit portion, said push-pull output circuit portion including :

first and second transistors each having an emitter, base and collector, said emitter of said first transistor connected to said collector of said second transistor, said base of said first transistor connected to said input circuit portion of said logic gate circuit, said base of said second transistor connected to said input circuit portion of said logic gate circuit;

a first resistor connected between said collector of said first transistor and a first source of reference potential;

a diode having an anode and a cathode, said anode of said diode connected to said base of said first transistor, said cathode of said diode connected to said collector of said first transistor;

a second resistor connected between said emitter of said second transistor and a second source of potential; and at least first and second outputs of said logic gate circuit respectively connected to said emitter of said first transistor.

10. Fault tolerant logic circuitry as recited in claim 8, or claim 9, wherein each of said logic gate circuits of said fault tolerant logic circuitry is a current switch type logic gate circuit.

LOGIC
PATH
1

LOGIC
PATH
2

WIRING DEFECT
SHORT

INPUT FROM THE
REDUNDANT CIRCUIT

INPUT FROM THE
REDUNDANT CIRCUIT

FIG. 1

IBM - FI 987 019

FIG. 2

FIG. 3

IBM - FI 987 019

+V

1  2  3  4

VR

OUT

VX

−V 1
(CURRENT SWITCH
CIRCUIT)

−V 1

PUSH−PULL OUTPUT
CIRCUIT PORTION

−V2

FIG. 4

+V

IN 1
IN 2

OUT

(TTL CIRCUIT)
FIG. 5

PUSH−PULL OUTPUT
CIRCUIT PORTION

−V

IBM − FI 987 019